# EUROPEAN PATENT APPLICATION

(11) **EP 2 256 434 A2**
(43) Date of publication of application: **01.12.2010**
(21) Application number: 10003768.8
(22) Date of filing: 08.04.2010
(51) Int. Cl.: F24J 2/54, H01L 31/052

(54) **Heating, air conditioning, air treatment using photovoltaic plants**

(30) Priority: 08.04.2009 IT MI20090563
(71) Applicant: Di Donato, Alfonso, 21054 Fagnano Olona (VA) (IT)
(72) Inventor: Di Donato, Alfonso, 21054 Fagnano Olona (VA) (IT)
(74) Representative: Altamura, Assunta

(57) **Abstract**

This invention improves the performance of the photovoltaic panels and reduces electrical consumption for the air conditioning and/or for hot sanitary water and/or comprises the treatment for the air entering in a civil building and/or leads to a reduction of costs for the winter heating, by using a heat pump water/water, with the possibility to dry the air, with an arrangement never used in the past. Finally, with this idea, the heat energy removed heat from the photovoltaic panels can be used for production of air conditioning (during the hot months of the year) by drying of the air (in the past the photovoltaic panels have never been used to produce heat for drying the air) and/or to produce sanitary hot water, by using heat pump. During the winter period, the above concepts are still applied, but with the addition of external air as heat source.

## Description

The solar concentration is done by keeping the photovoltaic panels in a fixed position, and moving only the reflective surfaces, not necessary rigid, around the photovoltaic panels.

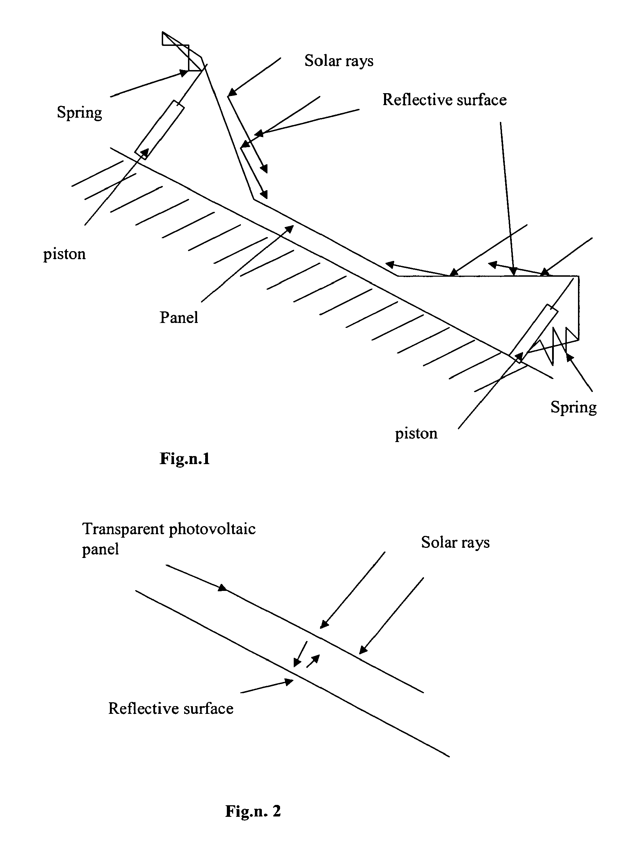

The movement of the reflective surfaces is made by pistons placed in the final part of the surface (see fig. 1 for reference), the pistons are moved by liquid. The reflective surface (which can also be more than one, placed on any side of the photovoltaic panel) can be either rigid or flexible, but in the last case the surface will be kept straight, in order to reflect the solar rays, by springs fixed on the pistons (the springs can be fixed to the cylinder of the piston, or to the piston, and/or to the bar that connects all the ends of the pistons).

The position of the pistons change, according to the position of the sun, to maximize the reflection of the solar rays on the photovoltaic panels. The advantage not to have rigid surfaces is that, in case of wind or snow, the surface change its shape, and the loads transmitted in the points where it is fixed, are lower than on a rigid surface.

The pistons filled in with a liquid have the advantage to have only one control panel from where the liquid in the circuit is moved, and this panel does not significantly change much with the increase of the size of the photovoltaic plant

It is also possible to use electrical pistons, this solution could be more economically convenient for small plants.

Finally, in addition and/or as alternative to the specified scheme above, it is also possible to use a reflective surface placed behind the panel, not necessarily integrated in the panel, to increase the suns radiation onto the panel (see fig. 2).

The solar concentration will reduce the investment cost of the photovoltaic technology, with the same energy produced.

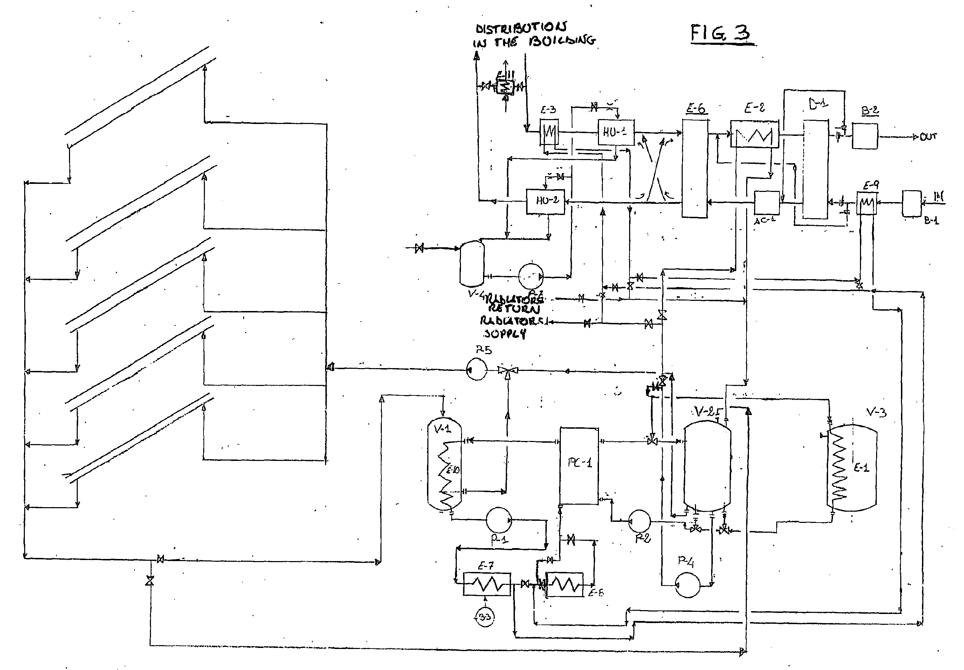

With reference to fig. 3, the cooling has been provided by a liquid in contact with the back of the photovoltaic panel. Once the heat has been removed from the liquid in contact with the photovoltaic panel, it is returned to the vessels from where it has been pumped: either vessel V-1 or V-2.

The cooling system of the photovoltaic panel can be integrated in the panel, using a serpentine placed on the back of the panel and in contact with the panel, or not integrated, by using a pipe with holes from where the fluid can exit, and then the fluid comes in contact with the back of the photovoltaic panels, thus cooling it.

The fluid is then collected by a plate placed on the back of the panels.

During the winter period, the liquid in the vessel V-1 is pumped onto the photovoltaic panels by pump P-5. The liquid is heated from being in contact with the photovoltaic panels. The heat is removed and then sent back to vessel V-1.

This vessel is the buffer from where the heat pump removes the heat. The liquid used to remove the heat is pumped to the heat pump by pump P-1. This liquid, part of a closed circuit, receives heat in the vessel V-1 from the exchanger E-10. In addition 3 exchangers are installed in the feeding circuit to the heat pump: the heat exchanger air/water, to heat the fluid before entering in the heat pump, using the heat of the external air (exchanger E-7 that exchanges heat with the external air, moved by the fan B-3), a heat exchanger that exchanges the heat with the air that is going out from the building (item E-9), the air coming out from the building heats the fluid before entering in the heat pump, and finally a heat exchanger (item E-8) that, if the weather is very cold, can supply energy to the water circuit by an external heat source with combustible material ( like an heat exchanger on top of a chimney and/or in a wood-burning stove and/or pellets and/or boiler with fuel).

It is possible to install, between the fan B-3 and the heat exchanger E-7, 2 vessels in parallel, containing any hygroscopic material (i.e. silica gel). The fan B-3 moves the external air inside one of the 2 vessels, while the other vessel is regenerated, removing the humidity from the hygroscopic substance, using a vacuum pump and/or supplying heat to the hygroscopic material (i.e. using the hot liquid inside the vessels V-2 or V-3, the liquid is pumped and exchanges heat, by an heat exchanger, placed inside the vessel with the hygroscopic material). The external air, passing through the vessel with the hygroscopic substance, is dried, this phenomena increase the temperature of the air, so the rate of exchange of heat in the exchanger E-7 will increase, and also the performances of the heat pump will increase, as the temperature of the liquid in the suction of the heat pump will be higher.

It is also possible to use 1 vessel instead of 2, filled with hygroscopic material, but, in this case, the regeneration of the hygroscopic material is done by moving the hygroscopic material in a small vessel, where the principles already explained will be applied (vacuum and/or heating) then, the regenerated hygroscopic material is sent back to the vessel.

The drying of the air can be realized using, instead of hygroscopic material, a desiccant wheel like the item D-1. The regeneration is realized by using part of the dried air, heated using a heat exchanger, with the liquid present in the vessels V-2 and/or V-3. The air used to regenerate the wheel can be sent back to the suction of the wheel itself.

Finally, considering the configuration shown on fig. 3, it is possible to dry the air that exits from the building using the dryer D-1. The air will heat the liquid in the suction of the heat pump using the heat exchanger E-9 that, in this configuration, is placed in the exit line of the air.

The regeneration of the desiccant wheel is done using a part of the inlet air to the building downstream from the exchanger E-6, that could also be additionally heated with an heat exchanger that uses the hot liquid of the vessels V-2 or V-3, to improve the regeneration.

With the process described above, the heat pump can heat the liquid of the vessel V-2, then the liquid from vessel V-2 will be sent inside the building for heating purposes, or the heat pump can heat the liquid inside vessel V-3 (the liquid in vessel V-3 will be heated by the heat exchanger E-1 placed inside the vessel), the vessel V-3 contains hot sanitary water to be used inside the building.

The liquid from the vessel V-2 and/or the heat exchanger E-1 (inside the vessel V-3) is circulated by pump P-2

The heat exchanger E-8, as an alternative, can also be placed on the line of the circuit where the heat pump supplies heat, downstream from the heat pump. In this configuration, on case of very cold weather, it is possible to avoid switching on the heat pump, as the heat necessary for heating purpose and heating of the sanitary water is supplied to the circuit by the heat exchanger E-8, and the source of heat can be with combustible material (i.e. like and heat exchanger placed in the chimney and/or wood-buming stove and/or pellets and/or boiler with fuel).

The distribution of water for heating purposes is done in 2 ways: the liquid from the vessel V-2 is pumped with the pump P-4 and sent to the heat exchanger E-3, that exchanger heats the inlet air to the building and/or using the hot water from vessel V-2, the water is pumped from pump P-4 to the building, where the liquid heats the ambient (i.e. by hot-water heating and/or radiant heating).

In the case of heating the air in the inlet of the building, the air is sent inside the building by the fan B-2, and the suction from the building is done by the fan B-1 to outside.

The position of the fans B-2 and B-1 shown in fig. 3 is for reference only.

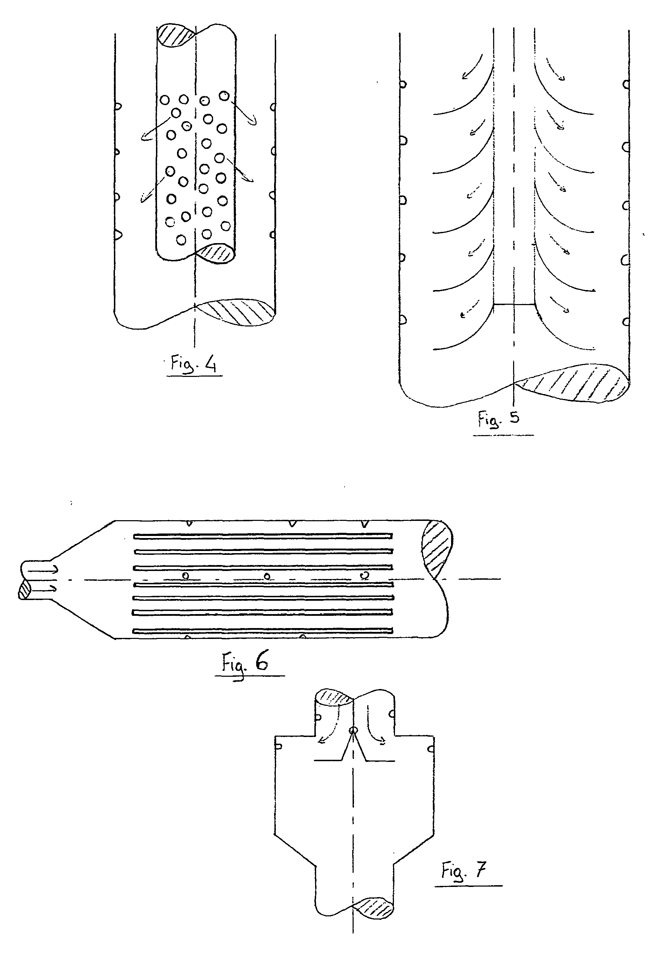

The air in the inlet of the building passes through an element covered by photocatalytic substances (element AC-1 shown in fig. 3), these substances, with the light coming from UV lamps, extract and retain the pollutants present in the air (like NOx, CO2, CO, etc.. In the fig. 4, 5, 6, 7 some possible configurations of the element covered by photocatalytic substances have been shown.

To increase the contact between the air and the photocatalytic substance, with the presence of UV light, it is possible to use the following configurations:
1. Pipe with holes and a closed end (see fig. 4): in this case the air coming from outside passing inside the pipe, is obliged to exit from the holes in the pipe, as the end part is closed. The pipe with holes is covered with photocatalytic substances inside and outside. Outside the piping there is another pipe covered inside by photocatalytic substances. Between the 2 pipes there is lighting by UV lamps. The air, after passing through the pipe with holes, will be in contact with the internal part of the second pipe, covered by photocatalytic substances.
2. Diffuser (see fig. 5): in this case the air is distributed by a diffuser, completely covered by photocatalytic substances. The air, after being distributed by the diffuser, is in contact with the internal part of the external pipe, and also that part is covered by photocatalytic substances. The light is placed in the internal part of the external pipe.
3. Bars parallel to the air direction (see fig. 6): in this case the air passes into a pipe, internally covered by by photocatalytic substances. Inside the pipes are some bars, and they are also covered by photocatalytic substances. UV lamps placed between the bars inside the pipe maximizes the diffusion of the light.
4. Bars not necessary parallel to the air flow: like solution of point 3 above, but the bars are not necessarily parallel to the air flow. The bars can also be substituted by plates.
5. Distribution on a wall (fig. 7): in this case the direction of the air is directed onto the surface of a bigger pipe. The surface that changes the direction of the air, and the surface with a larger diameter where the air goes in contact, are covered by photocatalytic substances, and the position of the UV light is in a way to maximize the diffusion of the light in this ambient.
6. Passage of air through beds of photocatalytic material: in this case the air is obliged to pass through beds made with pieces of photocatalytic material that, with the proper light, stops the pollutant present in the air.

For all configurations described above (points from 1 to 6) it is possible to add in the duct, before coming into the zone of contact between air and photocatalytic material, some surfaces with a angle, to give a vortex movement to the air, to help the contact between air and photocatalytic material.

The 2 streams of inlet and outlet air from the building exchange heat by the heat exchanger E-6. This exchanger can be a rotative exchanger or a plate heat exchanger.

The stream of inlet air is also heated by the heat exchanger E-3. The heat exchanger E-3, in the winter configuration shown in fig. 3, can be installed in the position indicated for the humidifier HU-2, or, if you do not want to move the position of the heat exchanger E-3, it is acceptable to send the air to the building on the suction of the heat exchanger E-6 in any point between the heat exchangers E-3 and E-6), so the exit of the air from the building change header. The air, after passing through the heat exchanger E-3, is distributed inside the buiding.

The stream of air that exits from the building gives the remaining heat to heat the liquid in the inlet of the heat pump, by the heat exchanger E-9.

Using the heat pump water/water with the technology described above, there are the following advantages compared to the existing technologies available: compared to the geothermal design the technology described above avoids the financial impact of drilling a deep hole in the ground, compared to the heat pump air/water the technology described above uses the heat from the photovoltaic panels, that otherwise is lost, and it also increases the production of the photovoltaic panels.

Another advantage of using the heat pump water/water instead of the heat pump air/water is that it is possible to have higher efficiency.

Another advantage of the described technology compared to the geothermal plants is that, in the case of very cold weather, the temperature of the liquid in the suction of the heat pump is higher than the temperature of the geothermal plants, so the performances of the heat pump are higher.

Finally, this invention has introduced the drying of the air as a source of winter heating.

During the summer period, the sun concentration on the photovoltaic panels is realized using the same principles already described for the winter period, and also the cooling system of the photovoltaic panels is the same.

Furthermore in this invention we want to realize the air conditioning of the buildings and the production of the hot sanitary water combining the cooling of the photovoltaic panels with the air drying.

The use of the drying of the air for air conditioning in a building has been already done in the past, but it has never been done using the photovoltaic panels as a heat source, and/or the use of heat pump water/water.

The drying of the air, for air conditioning of a building, works in the following way:
1 - The external air passes through a filter, then through the fan B-1, and then the air is sent to the distribution inside the building
2 - The temperature of the air coming from outside the building can be reduced using the heat exchanger air/water E-9. The advantage of this cooling is that the heat removed is sent to the vessel V-1, increasing the temperature of the liquid inside, and this liquid is used as a heat source from where the heat pump removes heat. This heat exchanger, used for the first time in this invention, has the advantage to decrease the temperature of the air in the inlet to building, and increase the temperature of the liquid in the vessel V-1 (the vessel V-1 could also be a swimming pool).
   In this way, as the temperature of the vessel V-1 increases, also the performances of the heat pump increases, as they depends on the temperature of the liquid placed in the vessel from where the heat is removed.
   This heat exchanger will also increase the performance of the desiccant wheel placed immediately after the heat exchanger E-9.
3 - The air, after passing through the heat exchanger E-9, is dried by the wheel D-1 (desiccant wheel covered from hygroscopic material, usually silica gel) that removes humidity from the stream that enters in the building, and gives this humidity to the stream that exits from the building.
   The desiccant wheel absorbs humidity from the stream of the inlet air, and gives it to the stream of outlet air. To allow the exit stream of air absorb humidity it is necessary that the temperature of this stream is higher than the temperature of the inlet stream.
4 - The inlet air stream, after giving humidity, increases in temperature, and passes through the item AC-1, where the air is in contact with the photocatalytic material, this phenomena is realized with the presence of UV light, placed inside the item AC-1, in this way the pollutants present in the inlet air are removed (i.e. NOx, CO, CO2)
5 - The air stream in the inlet of the building passes through the heat exchanger E-6 (heat exchanger air/air, type rotating or plate heat exchanger), and decreases the temperature, as the air stream exchanges heat with the air stream that exits by being sucked from the building, and also because the stream that exits from the building is cooled by the heat exchanger E-3 (that works in a similar way to the heat exchanger E-9 described above) and by increasing humidity in the humidifier HU-1 (the increase of humidity decrease the temperature in the air stream)
6 - The humidity of the air stream that enters in the building has increased (by means the humidifier HU-2) and this has the effect to reduce the temperature of the inlet air more
7 - The 2 humidifiers (HU-1 and HU-2) are feed by the pump P-7, this pump sends the water from the vessel V-4. The 2 humidifiers are cardboard humidifiers, but can also be used a different type of humidifier.
   On the bottom of the humidifiers is a collection point for the water which sends the water back to the vessel V-4.
8 - The air that exits from the building, after increasing its temperature by the heat exchanger E-6, is further heated by the heat exchanger E-2. The heat removed from the photovoltaic panels is supplied to the air stream that exits from the building, by the heat exchanger air/water E-2.
9 - The air that exits from the building, after passing through the heat exchanger E-2, passes through the rotating desiccant wheel D-1. The desiccant wheel is then regenerated and the humidity absorbed from the inlet air is removed.
10 - The fan B-2 sucks the air from the building, and pushes it outside.

During the summer period the cooling of the photovoltaic panels is realized by pumping a fluid from vessel V-1 or V-2 by pump P-5. The liquid, after cooling the photovoltaic panels, returns to the original vessel.

If the liquid is pumped onto the photovoltaic panels from vessel V-1, the pump P-1 sends the liquid to the heat pump, but it is also possible to increase the temperature of the liquid more in the inlet of the heat pump PC-1, by sending it through either 1 or 2 heat exchangers: the heat exchanger E-3, in this case, the liquid removes heat from the air that exits the building, and/or the heat exchanger E-9, where the liquid removes heat from the air that enters in the building.

The heat removed from these 2 streams increases the performances of the heat pump (as it increases the inlet temperature of the circuit from where the heat pump removes the heat) and the performance of the air conditioning (as it decreases the inlet temperature and exit temperature to/from the building). This optimization has never been done in the past.

It is also possible to use, inside the vessel V-1, a material with high thermal inerzia (like PCM) to accumulate heat.

With the summer configuration the liquid in the inlet of the heat pump will not exchange heat with the heat exchanger E-8. It is possible, based on the desired conditions, to use the heat exchanger air/water E-7, and exchange the heat with the external air, to change the temperature of the liquid at the inlet of the heat pump.

The heat pump PC-1 removes the heat from the circuit fed by pump P-1, and the pump supplies the heat to the circuit where the liquid is circulating by pump P-2. In this way, the sanitary water will be heated (vessel V-3) when the suction of pump P-2 is connected to the vessel V-3 where the liquid, with increased temperature, is circulating, after passing through the heat pump.

The heat to the sanitary water is supplied by the heat exchanger E-1, placed inside the vessel V-3.

When the suction of the pump P-2 is connected to the vessel V-2, the liquid passes through the heat pump, and after being heated, the fluid returns to vessel V-2.

From vessel V-2 the hot liquid is pumped, by pump P-4, to the heat exchanger E-2, and the exchanger will heat the air going out of the building, and this stream of air will regenerate the desiccant wheel D-1.

It is also possible to proceed to the production of air conditioning, without using heat pump PC-1.

In this case the liquid used for the cooling of the photovoltaic panels is pumped from vessel V-2, with pump P-5, to the photovoltaic panels and, after cooling down the photovoltaic panels, the liquid return to the vessel V-2. The liquid temperature inside the vessel V-2 will increase. There are 2 ways to remove the heat:
1 - The liquid is pumped from vessel V-2 to the exchanger E-2 using pump P-4, and the heat will be supplied to the stream of air that is going out of the building which regenerates the desiccant wheel D-1, while the liquid, after the cooling in the heat exchanger E-2, returns to the vessel V-2.
2 - The pump P-4 sends the liquid from vessel V-2 to the heat exchanger E-1, placed inside the vessel V-3. The heat is supplied to the hot water for sanitary use inside vessel V-3, and the liquid, after supplying the heat to the sanitary water, returns to vessel V-2.

It is possible to increase the plant flexibility with the installation of an additional pump placed on vessel V-2. This pump will send the liquid from vessel V-2 to the heat exchanger E-1, increasing the temperature of the sanitary hot water in vessel V-3.

In this case the liquid, after passing through the heat exchanger E-1, returns to the vessel V-2.

In questo caso il liquido, dopo essere passato all'interno dello scambiatore E-1, ritorna al serbatoio V-2.

If there is a desire to avoid the air distribution inside the building, instead is possible to use a cool liquid to cool down the building (i.e. using cold radiators or radiant cooling) is necessary to add an heat exchanger air/water (item E-11), placed downstream the humidifier HU-2. The liquid, passing through this exchanger, is cooled down by the air, and the air is then sent back to outside, while the liquid is distributed inside the building, at a lower temperature.

With this invention the air conditioning allows the production of the photovoltaic panels to increase and improves the drying of the air inside the building. With this invention the electrical consumption, compared to the technologies available on the market, is lower as, usually, the heat pump is idle, and when it works the performances are higher as the heat pump works always in a way to heat the temperature of the liquid in the circuit where the liquid is inside the building (instead of cooling down the temperature of the liquid in the circuit inside the building).

The performances of the heat pumps are higher when they work to increase the temperature of the liquid inside the building, instead of cooling down the temperature.

In the middle seasons, when it is air conditioning or heating are not necessary, the cooling of the photovoltaic panels can be realized in the way already described above, and the heat removed from the photovoltaic panels can be used for the production of hot sanitary water, as described before, and/or removed by the heat exchanger E-7 that removes the heat using the external air, moved by the fan B-3.

## Claims

1. Solar concentration on photovoltaic panels, using reflective surfaces that move according to the position of the sun, around the photovoltaic panels and/or fixed reflective surfaces placed behind the photovoltaic panels (see fig. 2) not necessarily integrated in the photovoltaic panels

2. Photovoltaic panels kept in fixed position and the suns rays are reflected onto them.

3. To use reflective surfaces rigid or not rigid, to be used for solar concentration

4. To use pistons, which move the reflective surfaces. The pistons are moved by liquid and/or electric motors.

5. Reflective surfaces that, if they are not rigid, are kept in position by springs

6. Cooling in the back of the photovoltaic panels, not necessarily integrated in the panel

7. Cooling of photovoltaic panels by liquid that cools down the back of the panel. The cooling is done by a serpentine filled with liquid, in contact with the back of the photovoltaic panel and/or by holes done on the liquid pipe in the back of the panel. When the liquid exits from the holes in the pipe, it is in contact with the back of the photovoltaic panels

8. Use of a heat pump, water/water type, to remove the heat from the photovoltaic panels, and use of the removed heat to produce sanitary hot water and/or air conditioning of the building by desiccant cooling and/or winter heating.

9. In the summer configuration, cooling of inlet air and exit air from the building, using the heat exchangers E-9 and E-3 shown in fig. 3, to improve the performances of the process of desiccant cooling and the performances of the heat pump.

10. Cooling of the photovoltaic panels (pumping the cooling liquid from vessel V-2, using the pump P-5) and use of the removed heat for desiccant cooling of air, sending the warm liquid from vessel V-2 to the heat exchanger E-2 to regenerate the desiccant wheel D-1, using the pump P-4, producing air conditioning and/or hot water for sanitary use (sending, in the last case, the hot liquid from vessel V-2 to the heat exchanger E-1 inside the vessel V-3, using the pump P-4 or an additional pump placed in the exit of the heat exchanger E-1), without using the heat pump

11. Winter heating of the liquid from where the heat pump removes heat, by the heat exchanger E-7, using the air moved from the ventilator B-3 and with the possibility of drying air, with the related increasing of temperature, using hygroscopic material with the following configurations: a) 2 vessels installed in parallel, 1 is passed through the air that is dried, while the other is regenerated, b) 1 vessel with the hygroscopic material, which is moved and regenerated by heat and/or vacuum in one place of the circuit, c) Use of desiccant wheel, regenerated with a part of dried air, d) Use of desiccant wheel D-1 in the position shown in fig. 3, to dry the air that exits from the building, to heat the liquid by the heat exchanger E-9 placed downstream D-1. The regeneration of D-1 is done by using part of the buildings inlet air, downstream the heat exchanger E-6. The regeneration air can also be heated.

12. To use a source of external heat, to supply energy to the liquid in the suction to the heat pump (heat exchanger E-8), and/or placed on the other circuit, after the heat pump PC-1 has heated the liquid.

13. To use photocatalytic materials to removed pollution from air which enters in the building

14. To use pipes with holes (fig. 4) and/or diffusers (fig. 5) and/or bars (or plates) not necessarily parallel to the air duct (fig. 6) and/or deviation of air on pipe of larger diameter (fig. 7), and/or passages through photocatalytic beds. All the configurations are covered by photocatalytic materials that, with proper light, remove the pollutants from the air in the inlet of the building. With all configurations it is possible to add in the duct, before arriving to the contact between air and photocatalytic material, some tilted surfaces, which rotates the air.

15. To use materials of high specific heat inside the vessel V-1, to increase the thermal inertia (i.e. PCM)

16. Combined or separated use of 1 or more solutions specified in points from 1 to 15
